# EUROPÄISCHE PATENTSCHRIFT

(11) **EP 3 251 156 B1**
(45) Veröffentlichungstag und Bekanntmachung des Hinweises auf die Patenterteilung: **26.08.2020**
(21) Anmeldenummer: 15820083.2
(22) Anmeldetag: 16.12.2015
(51) Int. Cl.: H01L 33/00, H01L 33/50, H01L 33/46

(54) **VERFAHREN ZUR HERSTELLUNG EINES OPTOELEKTRONISCHEN HALBLEITERBAUELEMENTS**
METHOD FOR PRODUCING AN OPTOELECTRONIC SEMICONDUCTOR COMPONENT
PROCÉDÉ DE FABRICATION D'UN COMPOSANT OPTOÉLECTRONIQUE À SEMI-CONDUCTEUR

(30) Priorität: 27.01.2015 DE 102015101143
(43) Veröffentlichungstag der Anmeldung: 06.12.2017
(73) Patentinhaber: OSRAM Opto Semiconductors GmbH, 93055 Regensburg (DE)
(72) Erfinder: LINKOV, Alexander, 93059 Regensburg (DE); HERRMANN, Siegfried, 94362 Neukirchen (DE)
(74) Vertreter: Epping - Hermann - Fischer
(86) Internationale Anmeldenummer: PCT/EP2015/080033
(87) Internationale Veröffentlichungsnummer: WO 2016/119973

(56) Entgegenhaltungen:
- WO-A1-2014/170271
- JP-A- 2009 182 241
- US-A1- 2011 147 778
- US-A1- 2013 193 465
- US-A1- 2014 231 850

## Beschreibung

Es wird ein Verfahren zur Herstellung einer Vielzahl optoelektronischer Halbleiterbauelemente angegeben.

Insbesondere soll die Homogenität des Farbeindrucks über den Winkel verbessert sein.

Ein Verfahren zur Herstellung einer Vielzahl optoelektronischer Halbleiterbauelemente ist beispielsweise in der Druckschrift WO 2014/170271 A1 beschrieben. Auch die Druckschriften US 2013/193465 A1, US 2014/231850 A1, JP 2009-182241 A und US 2011/147778 A1 beschreiben optoelektronische Halbleiterbauelemente und/oder Verfahren zu deren Herstellung.

Es soll ein Verfahren zur Herstellung eines optoelektronischen Halbleiterbauelements angegeben werden, dessen Licht in Abhängigkeit vom Betrachtungswinkel eine möglichst einheitliche Farbe aufweist.

Diese Aufgabe wird durch ein Verfahren mit den Schritten des Patentanspruchs 1 gelöst. Vorteilhafte Weiterbildungen und Ausführungsformen des Verfahrens sind Gegenstand der abhängigen Ansprüche.

Bei dem Verfahren zur Herstellung einer Vielzahl optoelektronischer Halbleiterbauelemente wird eine Vielzahl an Halbleiterchips bereitgestellt, die Strahlung eines ersten Wellenlängenbereichs von einer Strahlungsaustrittsfläche aussenden. Besonders bevorzugt umfasst der erste Wellenlängenbereich blaues Licht oder ist aus blauem Licht gebildet.

Die Halbleiterchips werden auf einen Hilfsträger aufgebracht. Der Hilfsträger weist beispielsweise eine Metallplatte auf, auf die eine doppelseitig klebende Folie laminiert ist. Auf der doppelseitig klebenden Folie können die Halbleiterchips fixiert werden.

Dann wird ein erstes Konversionsmaterial in Zwischenbereiche zwischen den Halbleiterchips aufgebracht. Das erste Konversionsmaterial ist dazu geeignet, elektromagnetische Strahlung des ersten Wellenlängenbereichs in elektromagnetische Strahlung eines zweiten Wellenlängenbereichs umzuwandeln, der von dem ersten Wellenlängenbereich verschieden ist. Der zweite Wellenlängenbereich kann sichtbares grünes Licht bis infrarotes Licht umfassen. Beispielsweise ist das erste Konversionsmaterial dazu geeignet, blaues Licht des Halbleiterchips in gelbes Licht umzuwandeln.

Mit anderen Worten ist das erste Konversionsmaterial wellenlängenkonvertierend ausgebildet. Mit dem Begriff "wellenlängenkonvertierend" ist vorliegend insbesondere gemeint, dass eingestrahlte elektromagnetische Strahlung eines bestimmten Wellenlängenbereichs in elektromagnetische Strahlung eines anderen, bevorzugt längerwelligen, Wellenlängenbereichs umgewandelt wird. In der Regel absorbiert ein wellenlängenkonvertierendes Element elektromagnetische Strahlung eines eingestrahlten Wellenlängenbereiches, wandelt diese durch elektronische Vorgänge auf atomarer und/oder molekularer Ebene in elektromagnetische Strahlung eines anderen Wellenlängenbereiches um und sendet die umgewandelte elektromagnetische Strahlung wieder aus. Insbesondere wird reine Streuung oder reine Absorption nicht als "wellenlängenkonvertierend" verstanden.

Über dem ersten Konversionsmaterial wird ein zweites Konversionsmaterial aufgebracht. Das zweite Konversionsmaterial ist dazu geeignet, elektromagnetische Strahlung des ersten Wellenlängenbereichs in elektromagnetische Strahlung des zweiten Wellenlängenbereichs oder eines dritten Wellenlängenbereichs umzuwandeln, wobei der dritte Wellenlängenbereich von dem ersten Wellenlängenbereich und dem zweiten Wellenlängenbereich bevorzugt verschieden ist. Es ist auch möglich, dass der erste Wellenlängenbereich und der dritte Wellenlängenbereich gleich sind.

Gemäß der Erfindung wird der Hilfsträger wieder entfernt.

Gemäß der Erfindung werden die Halbleiterbauelemente vereinzelt, beispielsweise durch Sägen. Das erste Konversionsmaterial bildet bei den fertigen Halbleiterbauelementen eine erste Konversionsschicht auf den Seitenflanken des Halbleiterchips und das zweite Konversionsmaterial eine zweite Konversionsschicht auf der Strahlungsaustrittsfläche des Halbleiterchips. Besonders bevorzugt unterscheidet sich die erste Konversionsschicht von der zweiten Konversionsschicht. Auf diese Art und Weise kann die Farbe des von dem Halbleiterchip ausgesandten Lichts besonders homogen in Abhängigkeit des Betrachtungswinkels eingestellt werden.

Gemäß einer Ausführungsform des Verfahrens wird vor dem Aufbringen des ersten Konversionsmaterials eine Barriere um die Halbleiterchips in einem Randbereich des Hilfsträgers aufgebracht. Bevorzugt bildet die Barriere eine geschlossene Form um die Halbleiterchips aus. Beispielsweise ist die Barriere als geschlossener Ring um die Halbleiterchips auf dem Hilfsträger ausgebildet. Die Barriere kann beispielsweise aus Silikon gebildet sein oder ein Silikon enthalten.

Gemäß der Erfindung ist das erste Konversionsmaterial ein flüssiges Harz, in das Leuchtstoffpartikeln eingebracht sind. Die Leuchtstoffpartikeln verleihen dem ersten Konversionsmaterial die wellenlängenkonvertierenden Eigenschaften. Bei dem Harz kann es sich beispielsweise um ein Silikon handeln. Das Harz wird vor der Vereinzelung ausgehärtet.

Das erste Konversionsmaterial wird in flüssiger Form, beispielsweise durch Dispensen oder Gießen, zwischen die Halbleiterchips eingebracht.

Die Barriere ist besonders bevorzugt dazu ausgebildet, einen Damm für das flüssige erste Konversionsmaterial zu bilden und zu verhindern, dass das Konversionsmaterial von dem Hilfsträger herunterfließt.

Gemäß der Erfindung ist auch das zweite Konversionsmaterial ein flüssiges Harz, in das Leuchtstoffpartikeln eingebracht sind, die dem zweiten Konversionsmaterial die wellenlängenkonvertierenden Eigenschaften verleihen. Das Harz wird wiederum vor der Vereinzelung ausgehärtet.

Für die Leuchtstoffpartikeln ist beispielsweise eines der folgenden Materialien geeignet: mit seltenen Erden dotierte Granate, mit seltenen Erden dotierte Erdalkalisulfide, mit seltenen Erden dotierte Thiogallate, mit seltenen Erden dotierte Aluminate, mit seltenen Erden dotierte Silikate, mit seltenen Erden dotierte Orthosilikate, mit seltenen Erden dotierte Chlorosilikate, mit seltenen Erden dotierte Erdalkalisiliziumnitride, mit seltenen Erden dotierte Oxynitride, mit seltenen Erden dotierte Aluminiumoxinitride, mit seltenen Erden dotierte Siliziumnitride, mit seltenen Erden dotierte Sialone.

Das zweite Konversionsmaterial kann in flüssiger Form beispielsweise durch Spraycoaten vollflächig auf das erste Konversionsmaterial und auf die Strahlungsaustrittsflächen der Halbleiterchips aufgebracht werden.

Das zweite Konversionsmaterial wird in flüssiger Form auf das ebenfalls flüssige erste Konversionsmaterial 2. aufgebracht. In diesem Fall sedimentieren Leuchtstoffpartikeln aus dem zweiten Konversionsmaterial gezielt in das erste Konversionsmaterial, in dem der Verbund aus Halbleiterchips und flüssigen Konversionsmaterialien einige Zeit nicht weiterverarbeitet wird. Durch die Sedimentation kann ein Konzentrationsgradient entlang der Seitenflanke der Halbleiterchips gezielt eingestellt werden, der zu einem besonders homogenen Farbeindruck des von dem fertigen Halbleiterbauelement ausgesandten Lichts führt.

Gemäß einer weiteren Ausführungsform des Verfahrens wird vor dem Aufbringen des ersten Konversionsmaterials ein reflektierendes Material in die Zwischenbereiche zwischen den Halbleiterchips aufgebracht. Besonders bevorzugt wird das reflektierende Material in direktem Kontakt auf den Hilfsträger aufgebracht. Beispielsweise ist das reflektierende Material ebenfalls ein Harz, in das reflektierende Partikeln eingebracht sind, die dem reflektierenden Material die reflektierenden Eigenschaften verleihen. Bei den reflektierenden Partikeln kann es sich beispielsweise um Titanoxidpartikeln handeln und bei dem Harz um ein Silikon.

Beispielsweise wird das reflektierende Material zunächst in flüssiger Form zur Verfügung gestellt und durch Dispensen oder Gießen in die Zwischenbereiche zwischen den Halbleiterchips eingebracht. Im weiteren Verfahren wird das reflektierende Material dann ausgehärtet, so dass sich zumindest teilweise eine reflektierende Schicht auf der Seitenflanke des Halbleiterchips ausbildet.

Gemäß einer weiteren Ausführungsform des Verfahrens wird der Hilfsträger entfernt, so dass eine rückseitige Kontaktstruktur des Halbleiterchips frei zugänglich ist. Dann wird die Kontaktstruktur durch Aufbringen einer metallischen Struktur seitlich erweitert. Die metallische Struktur kann beispielsweise mittels Fotolithographie oder durch Drucken einer Metallpaste aufgebracht werden. Als Druckverfahren ist etwa Siebdruck oder Schablonendruck geeignet.

Gemäß einer weiteren Ausführungsform des Verfahrens werden auf einer von den Strahlungsaustrittsflächen des Halbleiterchips abgewandten Hauptfläche des zweiten Konversionsmaterials geometrische Auskoppelstrukturen aufgesetzt. Die Auskoppelstrukturen sind dazu geeignet, die Strahlungsauskopplung aus dem Halbleiterchip zu verbessern.

Gemäß einer weiteren Ausführungsform des Verfahrens wird eine lichtdurchlässige Schicht auf die zweite Konversionsschicht aufgebracht, die durch den Vereinzelungsschritt an den dabei entstehenden Seitenflanken so strukturiert wird, dass die Auskopplung aus dem Halbleiterbauelement verbessert wird. Beispielsweise wird die lichtdurchlässige Schicht an den Seitenflächen angeschrägt.

Die Konzentration der Leuchtstoffpartikeln in dem Harz des ersten Konversionsmaterials und/oder in dem Harz der ersten Konversionsschicht liegt bevorzugt zwischen einschließlich 0,1 Gew% und einschließlich 60 Gew%.

Die Konzentration der Leuchtstoffpartikeln in dem Harz des zweiten Konversionsmaterials und/oder in dem Harz der zweiten Konversionsschicht liegt bevorzugt zwischen einschließlich 0,1 Gew% und einschließlich 70 Gew%.

Weil das erste Konversionsmaterial durch ein Harz gebildet ist, in das Leuchtstoffpartikeln eingebracht sind, und das zweite Konversionsmaterial ebenfalls durch ein Harz gebildet ist, in das Leuchtstoffpartikeln eingebracht sind, so kann die Konzentration der Leuchtstoffpartikeln in dem ersten Harz und die Leuchtstoffpartikelkonzentration in dem zweiten Harz durch eine Simulation bestimmt werden.

Bei der Simulation werden bevorzugt zunächst die Farbtemperatur der von dem fertigen Halbleiterbauelement ausgesandten Strahlung und die Konzentration der Leuchtstoffpartikeln in dem ersten Konversionsmaterial festgelegt. Ausgehend von diesen Werten wird die Konzentration der Leuchtstoffpartikeln in dem zweiten Konversionsmaterial iterativ bestimmt.

Besonders bevorzugt ist die erste Konversionsschicht von der zweiten Konversionsschicht verschieden. Beispielsweise unterscheiden sich die erste Konversionsschicht und die zweite Konversionsschicht durch die Konzentration der Leuchtstoffpartikeln oder durch ihre Dicke. Weiterhin ist es auch möglich, dass die erste Konversionsschicht ein anders Harz aufweist als die zweite Konversionsschicht. Es ist auch möglich, dass die erste Konversionsschicht andere Leuchtstoffpartikeln aufweist als die zweite Konversionsschicht. Beispielsweise unterscheiden sich die Leuchtstoffpartikeln durch ihre Materialzusammensetzung. Es ist aber auch möglich, dass die Leuchtstoffpartikeln der ersten Konversionsschicht zwar aus dem gleichen Material gebildet sind wie die Leuchtstoffpartikeln der zweiten Konversionsschicht, aber eine andere Partikelgröße aufweisen. Bevorzugt weist die erste Konversionsschicht eine Dicke auf, die zwischen einschließlich 50 Mikrometer und einschließlich 300 Mikrometer liegt.

Besonders bevorzugt schwankt die Dicke der ersten Konversionsschicht über ihre gesamte Fläche nur wenig. Bevorzugt weicht die Dicke der ersten Konversionsschicht über ihre gesamte Ausdehnung nicht mehr als 20 %, besonders bevorzugt nicht mehr als 10 %, von einem Mittelwert ab.

Bevorzugt weist die zweite Konversionsschicht eine Dicke auf, die zwischen einschließlich 10 Mikrometer und einschließlich 300 Mikrometer liegt.

Besonders bevorzugt schwankt die Dicke der zweiten Konversionsschicht über ihre gesamte Fläche nur wenig. Bevorzugt weicht die Dicke der zweiten Konversionsschicht über ihre gesamte Ausdehnung nicht mehr als 20 %, besonders bevorzugt nicht mehr als 10 %, von einem Mittelwert ab.

Bei dem Halbleiterbauelement wird Licht, das über die Seitenflanken des Halbleiterchips ausgesandt wird, durch die erste Konversionsschicht zumindest teilweise konvertiert und Licht, das von der Strahlungsaustrittsfläche des Halbleiterchips ausgesandt wird, durch die zweite Konversionsschicht zumindest teilweise konvertiert. Das Halbleiterbauelement sendet bevorzugt mischfarbiges Licht aus, das aus unkonvertiertem Licht des Halbleiterchips und durch die beiden Konversionsschichten aus konvertiertem Licht gebildet ist. Besonders bevorzugt weist dieses mischfarbige Licht einen Farbort im weißen Bereich der CIE-Normfarbtafel auf.

Aufgrund der unterschiedlichen Eigenschaften der ersten Konversionsschicht und der zweiten Konversionsschicht kann die Farbe des mischfarbigen Lichtes insbesondere über den Winkel homogenisiert werden. Wird zu wenig Licht, das von den Seitenflanken des Halbleiterchips ausgesandt wird, durch die erste Konversionsschicht konvertiert, so erscheint ein Ring mit der Farbe des Lichts des Halbleiterchips, zum Beispiel blau, in einem Außenbereich des Abstrahlkegels des Halbleiterbauelements. Wird hingegen zu viel Licht, das von den Seitenflanken des Halbleiterchips ausgesandt wird, durch die erste Konversionsschicht konvertiert, so erscheint ein Ring mit der Farbe des konvertierten Lichts, zum Beispiel gelb, in einem Außenbereich des Abstrahlkegels des Halbleiterbauelements. Eine derartige Farbinhomogenität in der Abstrahlcharakteristik kann mit dem vorliegenden Konzept mit Vorteil zumindest verringert werden.

Insbesondere die oben beschriebene Simulation erlaubt es, die Konzentration der Leuchtstoffpartikeln in den beiden Konversionsschichten so festzulegen, dass eine einheitliche Farbe eines von dem Halbleiterbauelement ausgesandten mischfarbigen Lichts erzielt wird.

Besonders bevorzugt weist der Halbleiterchip einen Träger auf, auf den eine epitaktische Halbleiterschichtenfolge mit einer aktiven Zone aufgebracht ist, die im Betrieb elektromagnetische Strahlung des ersten Wellenlängenbereichs erzeugt. Beispielsweise umfasst die epitaktische Halbleiterschichtenfolge eine p-dotierte Halbleiterschicht und eine n-dotierte Halbleiterschicht, wobei die aktive Zone durch den pn-Übergang dieser beiden Schichten gebildet ist. Die n-dotierte Halbleiterschicht grenzt in der Regel an den Träger an.

Die epitaktische Halbleiterschichtenfolge basiert besonders bevorzugt auf einem Nitrid-Verbindungshalbleitermaterial. Nitrid-Verbindungshalbleitermaterialien sind Verbindungshalbleitermaterialien aus dem System InₓAl_{y}Ga_{1-x-y}N mit 0 ≤ x ≤ 1, 0 ≤ y ≤ 1 und x+y ≤ 1.

Zwischen der epitaktischen Halbleiterschichtenfolge und den Kontaktstrukturen ist bevorzugt eine Spiegelschicht ausgebildet, die dazu vorgesehen ist, Strahlung der aktiven Zone zur Strahlungsaustrittsfläche des Halbleiterchips zu lenken. Die Spiegelschicht kann elektrisch leitend oder elektrisch isolierend ausgebildet sein.

Die Strahlungsaustrittsfläche ist bevorzugt durch die Hauptfläche des Trägers gebildet, die von der epitaktischen Halbleiterschichtenfolge abgewandt ist. Besonders bevorzugt sind auf der Hauptfläche des Halbleiterchips, die der Strahlungsaustrittsfläche gegenüberliegt, zwei Kontaktstrukturen angeordnet, über die der Halbleiterchip elektrisch kontaktiert werden kann. Ein derartiger Halbleiterchip wird auch als Flip-Chip bezeichnet.

Der Träger ist besonders bevorzugt durchlässig für elektromagnetische Strahlung ausgebildet, die von der aktiven Zone erzeugt wird. Weiterhin kann es sich bei dem Träger gleichzeitig um ein Aufwachsubstrat für die epitaktische Halbleiterschichtenfolge handeln. Beispielsweise weist der Träger Saphir auf oder ist aus Saphir gebildet. Saphir ist insbesondere als Aufwachssubstrat für eine Nitrid-basierte Halbleiterschichtenfolge geeignet.

Zur elektrischen Kontaktierung der n-leitenden Halbleiterschicht umfasst der Halbleiterchip bevorzugt Knüpfel, die sich in vertikaler Richtung, also entlang der Seitenflanken des Halbleiterchips, von den Kontaktstrukturen bis zu der n-leitenden Halbleiterschicht hin erstrecken. Jedes Knüpfel weist bevorzugt eine elektrisch isolierende äußere Schicht und eine elektrisch leitende innere Schicht auf.

Gemäß einer Ausführungsform des Verfahrens wird die zweite Konversionsschicht direkt auf die Strahlungsaustrittsfläche des Halbleiterchips und direkt auf die erste Konversionsschicht aufgebracht. Bevorzugt schließt die erste Konversionsschicht bündig mit der Strahlungsaustrittsfläche des Halbleiterchips ab.

Gemäß einer weiteren Ausführungsform des Verfahrens werden auf der Strahlungsaustrittsfläche gegenüberliegenden Hauptfläche des Halbleiterbauelements zwei Kontaktstrukturen angeordnet, über die Halbleiterchips elektrisch kontaktiert werden können. Besonders bevorzugt sind die Kontaktstrukturen durch zusätzliche metallische Strukturen erweitert. Die metallischen Strukturen erstrecken sich bevorzugt entlang der der Strahlungsaustrittsfläche gegenüber liegenden Hauptfläche des Halbleiterchips bis zu dessen Seitenflanken.

Gemäß einer weiteren Ausführungsform des Verfahrens wird auf der Seitenflanke des Halbleiterchips eine reflektierende Schicht angeordnet. Die reflektierende Schicht grenzt bevorzugt an die Hauptfläche des Halbleiterchips an, die der Strahlungsaustrittsfläche gegenüberliegt. Besonders bevorzugt bedeckt die reflektierende Schicht nur einen Teil der Seitenflanke des Halbleiterchips, während ein weiterer Teil der Seitenflanke des Halbleiterchips von der ersten Konversionsschicht bedeckt ist. Beispielsweise ist die Seitenflanke mit der reflektierenden Schicht und der ersten Konversionsschicht zusammen vollständig bedeckt.

Beispielsweise ist die reflektierende Schicht aus einem Harz gebildet, in das reflektierende Partikeln, wie Titandioxidpartikeln, eingebracht sind. Bei dem Harz kann es sich beispielsweise um ein Silikon handeln.

Bei dem Halbleiterbauelement handelt es sich bevorzugt um eine Leuchtdiode.

Weitere vorteilhafte Ausführungsformen und Weiterbildungen der Erfindung ergeben sich aus den im Folgenden in Verbindung mit den Figuren beschriebenen Ausführungsbeispielen.

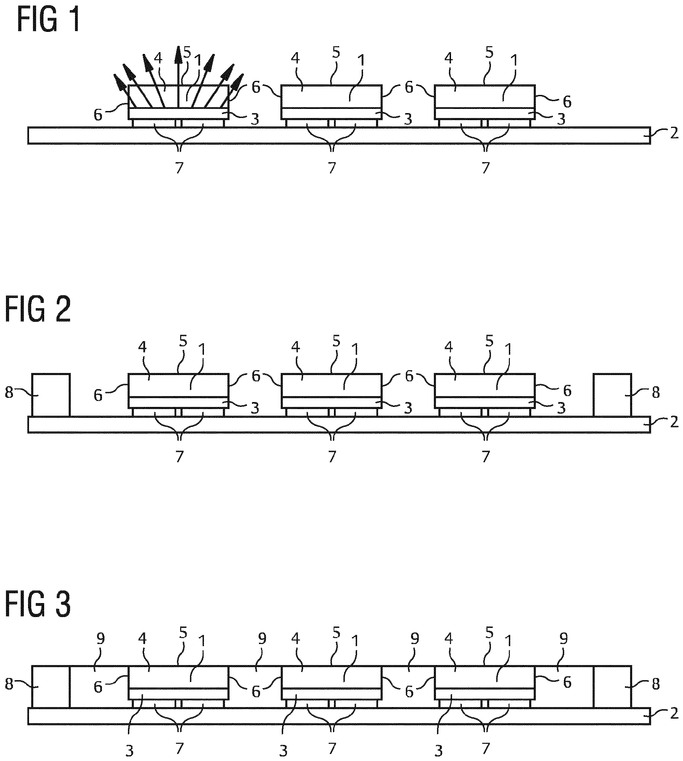

Anhand der schematischen Schnittdarstellungen der Figuren 1 bis 4 wird ein erstes Ausführungsbeispiel eines erfindungsgemäßen Verfahrens beschrieben.

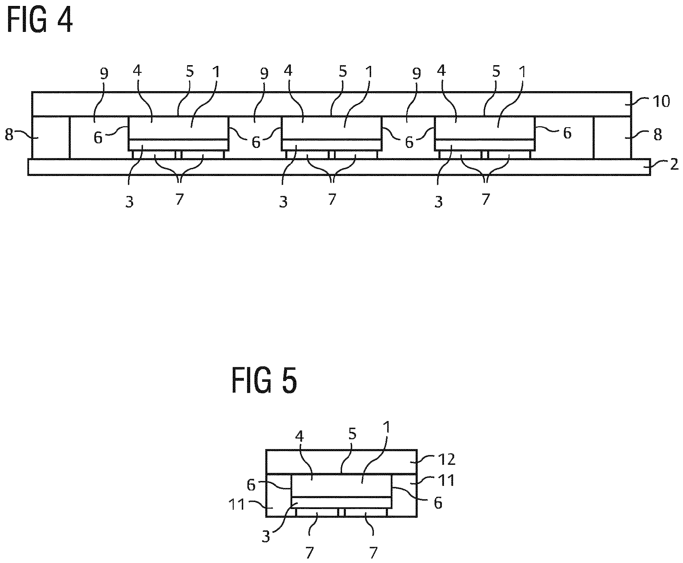

Figur 5 zeigt eine schematische Schnittdarstellung eines Halbleiterbauelements gemäß einem nicht erfindungsgemäßen Beispiel.

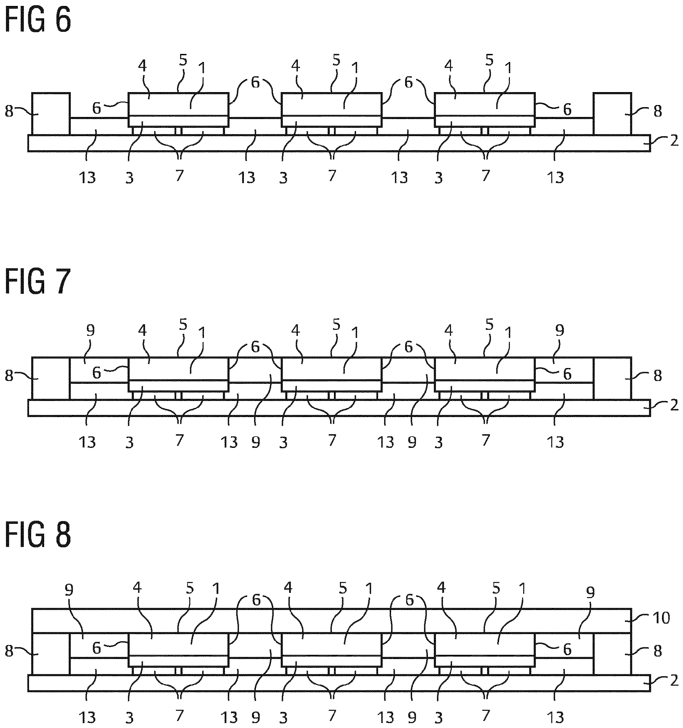

Anhand der schematischen Schnittdarstellungen der Figuren 6 bis 8 wird ein weiteres Ausführungsbeispiel eines erfindungsgemäßen Verfahrens beschrieben.

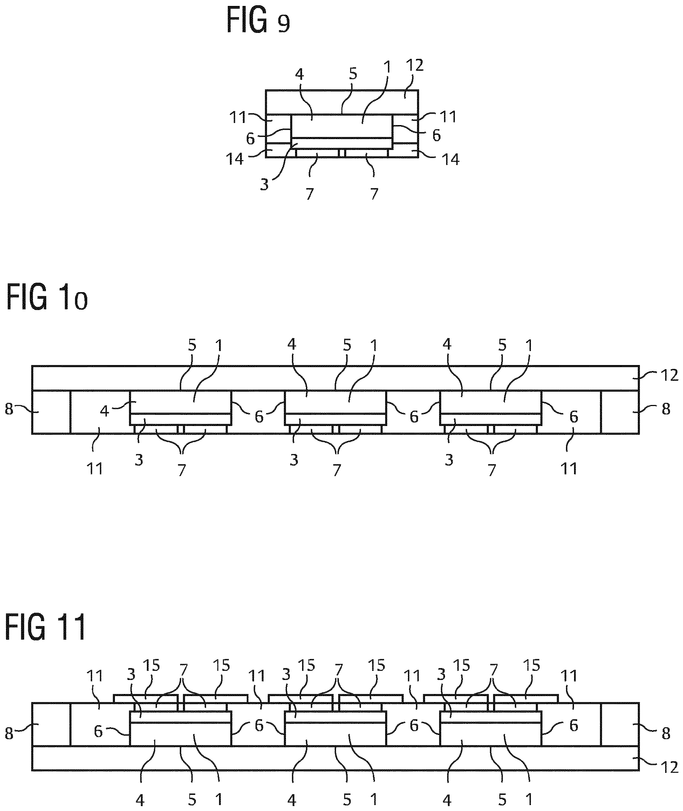

Figur 9 zeigt eine schematische Schnittdarstellung eines Halbleiterbauelements gemäß einem nicht erfindungsgemäßen Beispiel.

Anhand der schematischen Schnittdarstellungen der Figuren 10 bis 11 wird ein weiteres Ausführungsbeispiel eines erfindungsgemäßen Verfahrens beschrieben.

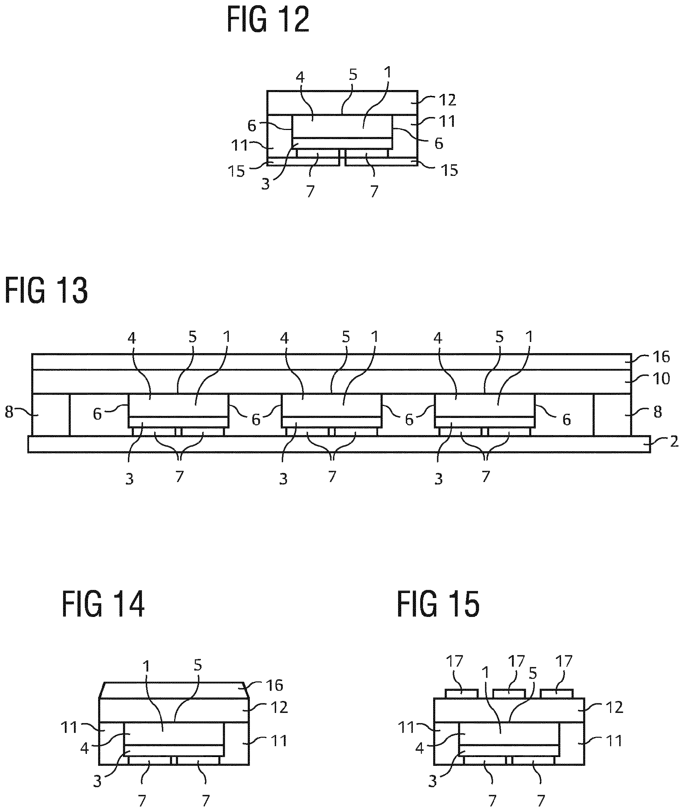

Figur 12 zeigt eine schematische Schnittdarstellung eines Halbleiterbauelements gemäß einem nicht erfindungsgemäßen Beispiel.

Anhand der schematischen Schnittdarstellungen der Figuren 13 bis 14 wird ein weiteres Ausführungsbeispiel eines erfindungsgemäßen Verfahrens beschrieben.

Figur 15 zeigt eine schematische Schnittdarstellung eines Halbleiterbauelements gemäß einem nicht erfindungsgemäßen Beispiel.

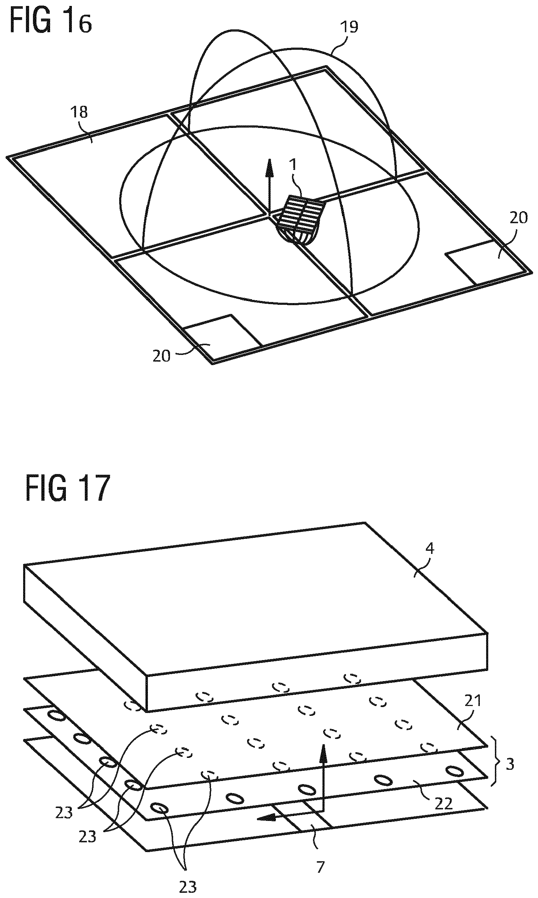

Anhand der schematischen Darstellungen der Figuren 16 und 17 wird eine Simulation gemäß einem Ausführungsbeispiel eines erfindungsgemäßen Verfahrens zur Bestimmung der Leuchtstoffkonzentration in einer der beiden Konversionsschichten näher erläutert.

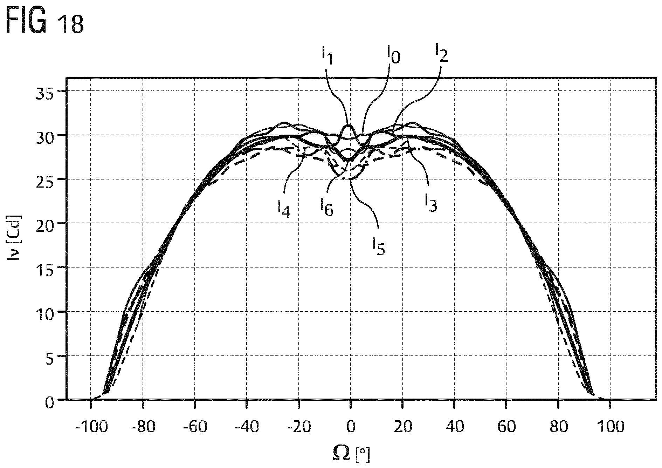

Figuren 18 bis 22 zeigen exemplarische Simulationsergebnisse. Gleiche, gleichartige oder gleich wirkende Elemente sind in den Figuren mit denselben Bezugszeichen versehen. Die Figuren und die Größenverhältnisse der in den Figuren dargestellten Elemente untereinander sind nicht als maßstäblich zu betrachten. Vielmehr können einzelne Elemente, insbesondere Schichtdicken, zur besseren Darstellbarkeit und/oder zum besseren Verständnis übertrieben groß dargestellt sein.

Bei dem Verfahren gemäß dem erfindungsgemäßen Ausführungsbeispiel der Figuren 1 bis 4 wird eine Vielzahl an Halbleiterchips 1 auf einen Hilfsträger 2 aufgebracht (Figur 1). Die Halbleiterchips 1 weisen eine epitaktische Halbleiterschichtenfolge 3 auf, die auf einem Träger 4 aufgebracht ist. Die epitaktische Halbleiterschichtenfolge 3 umfasst eine aktive Zone, die im Betrieb des Halbleiterchips 1 elektromagnetische Strahlung, vorliegend blaues Licht, erzeugt.

Der Träger 4 ist strahlungsdurchlässig ausgebildet, insbesondere für das Licht der aktiven Zone. Der Träger 4 ist beispielsweise aus Saphir gebildet. Das Licht, das in der aktiven Zone erzeugt wird, wird von einer Strahlungsaustrittsfläche 5 des Halbleiterchips 1, die durch eine Hauptfläche des Trägers 4 gebildet ist, ausgesandt. Weiterhin wird Licht auch von Seitenflanken 6 des Trägers 4 aus dem Halbleiterchip ausgekoppelt. Das Licht der aktiven Zone durchläuft den Träger 4 bis zu dessen Strahlungsaustrittsfläche 5 oder bis zu seinen Seitenflanken 6 (siehe die Pfeile in Figur 1).

Auf der Hauptfläche der epitaktischen Halbleiterschichtenfolge 3, die von dem Träger 4 abgewandt ist, sind zwei Kontaktstrukturen 7 aufgebracht, die dazu vorgesehen sind, den Halbleiterchip 1 elektrisch zu kontaktieren.

In einem nächsten Schritt, der schematisch in Figur 2 dargestellt ist, wird in einem Außenbereich des Hilfsträgers 2 eine Barriere 8 aufgebracht. Die Barriere 8 ist vorliegend ringförmig ausgebildet und bildet eine geschlossene Kontur um die Halbleiterchips 1. Die Barriere ist bei dem Ausführungsbeispiel der Figur 2 aus Silikon ausgebildet.

Dann wird ein erstes Konversionsmaterial 9 in die Zwischenräume zwischen die Halbleiterchips 1 und zwischen den äußersten Halbleiterchip 1 und die Barriere 8 eingebracht (Figur 3), beispielsweise durch Jetten oder Dispensen. Das erste Konversionsmaterial 9 liegt hierbei als ein flüssiges Harz vor, in das Leuchtstoffpartikeln (nicht dargestellt) eingebracht sind. Die Barriere 8 verhindert hierbei, dass das erste Konversionsmaterial 9 von dem Hilfsträger 2 abfließt. Das erste Konversionsmaterial 9 erstreckt sich bis zur Strahlungsaustrittsfläche 5 der Halbleiterchips 1 und schließt bündig mit der Strahlungsaustrittsfläche 5 der Halbleiterchips 1 ab.

Die Leuchtstoffpartikeln des ersten Konversionsmaterials 9 sind dazu geeignet, Strahlung des Halbleiterchips 1 des ersten Wellenlängenbereichs in elektromagnetische Strahlung eines zweiten Wellenlängenbereichs umzuwandeln. Der zweite Wellenlängenbereich ist bei dem vorliegenden Ausführungsbeispiel gelbes Licht.

In einem nächsten Schritt wird ein zweites Konversionsmaterial 10 aufgebracht, das dazu geeignet ist, Strahlung des Halbleiterchips 1 zumindest teilweise in eine andere elektromagnetische Strahlung zu konvertieren (Figur 4). Beispielsweise konvertiert auch das zweite Konversionsmaterial 10 Strahlung des Halbleiterchips 1 in Strahlung des zweiten Wellenlängenbereichs. Weiterhin ist es aber auch möglich, dass das zweite Konversionsmaterial 10 die Strahlung des Halbleiterchips 1 in einen dritten Wellenlängenbereich umwandelt, der von dem ersten und dem zweiten Wellenlängenbereich verschieden ist.

Das zweite Konversionsmaterial 10 wird hierbei vollflächig auf den Verbund aus Hilfsträger 2, Halbleiterchips 1 und erstem Konversionsmaterial 9 aufgebracht. Beispielsweise kann das zweite Konversionsmaterial 10 durch Spraycoaten in flüssiger Form aufgebracht werden. Das zweite Konversionsmaterial 10 liegt hierbei als flüssiges Harz vor, in das Leuchtstoffpartikeln eingebracht sind. Die Leuchtstoffpartikeln verleihen dem zweiten Konversionsmaterial 10 die wellenlängenkonvertierenden Eigenschaften.

Anschließend wird das Harz des ersten Konversionsmaterials 9 und des zweiten Konversionsmaterials 10 ausgehärtet und der Hilfsträger 2 entfernt. Schließlich werden die Halbleiterbauelemente vereinzelt, wobei das erste Konversionsmaterial 9 eine erste Konversionsschicht 11 auf den Seitenflanken 6 des Halbleiterchips 1 bildet und das zweite Konversionsmaterial 10 eine zweite Konversionsschicht 12 auf der Strahlungsaustrittsfläche 5 des Halbleiterchips 1 bildet (Figur 5).

Die schematische Schnittdarstellung der Figur 5 zeigt ein Halbleiterbauelement gemäß einem ersten nicht erfindungsgemäßen Beispiel, wie es durch das Verfahren gemäß dem Ausführungsbeispiel der Figuren 1 bis 4 hergestellt werden kann. Das Halbleiterbauelement gemäß dem Beispiel der Figur 5 weist einen Halbleiterchip 1 auf, auf dessen Strahlungsaustrittsfläche 5 die zweite Konversionsschicht 12 in direktem Kontakt aufgebracht ist. Die zweite Konversionsschicht 12 ragt seitlich über die Strahlungsaustrittsfläche 5 des Halbleiterchips 1 hinaus und bedeckt die erste Konversionsschicht 11, die sich entlang der Seitenflanken 6 des Halbleiterchips 1 bis zu den Kontaktstrukturen 7 erstreckt.

Elektromagnetische Strahlung, die in der aktiven Zone des Halbleiterchips 1 erzeugt wird, durchläuft den Träger 2 zumindest teilweise und wird über die Seitenflanken 6 des Trägers 2 oder über dessen Strahlungsaustrittsfläche 5 aus dem Halbleiterchip 1 ausgekoppelt. Diese ausgekoppelte elektromagnetische Strahlung durchläuft dann die erste Konversionsschicht 11 oder die zweite Konversionsschicht 12 und wird dort zumindest teilweise in Strahlung eines anderen Wellenlängenbereichs umgewandelt. Besonders bevorzugt sind die Konversionsschichten 11, 12 derart ausgebildet, dass sie einen Teil des blauen Lichts der aktiven Zone in gelbes Licht umwandeln, sodass das gesamte Halbleiterbauelement weißes Licht aussendet.

Bei dem Verfahren gemäß dem erfindungsgemäßen Ausführungsbeispiel der Figuren 6 bis 8 wird im Unterschied zu dem Verfahren gemäß den Figuren 1 bis 4 vor dem Aufbringen des ersten Konversionsmaterials 9 ein reflektierendes Material 13 in die Zwischenbereiche zwischen den Halbleiterchips 1 auf dem Hilfsträger 2 aufgebracht. Das reflektierende Material 13 ist hierbei ebenfalls zunächst flüssig ausgebildet. Es ist aus einem Harz gebildet, in das reflektierende Partikeln eingebracht sind. Auch das reflektierende Material 13 kann beispielsweise durch Dispensen oder Gießen in die Zwischenräume eingebracht werden (siehe Figur 6).

In einem nächsten Schritt, der schematisch in Figur 7 dargestellt ist, wird dann auf das reflektierende Material 13 das erste Konversionsmaterial 9 in flüssiger Form aufgebracht. Besonders bevorzugt wird hierbei vor dem Aufbringen des ersten Konversionsmaterials 9 das reflektierende Material 13 ausgehärtet.

Dann wird ein zweites Konversionsmaterial 10 auf das erste Konversionsmaterial 9 und die Halbleiterchips 1 aufgebracht, wie bereits anhand von Figur 4 beschrieben (Figur 7). Schließlich wird der Hilfsträger 2 entfernt und die Halbleiterbauelemente vereinzelt (nicht dargestellt).

Bei dem Verfahren gemäß dem erfindungsgemäßen Ausführungsbeispiel der Figuren 6 bis 8 kann ein Halbleiterbauelement erzeugt werden, wie es beispielsweise in Figur 9 schematisch dargestellt ist.

Im Unterschied zu dem Halbleiterbauelement gemäß dem nicht erfindungsgemäßen Beispiel der Figur 5 weist das Halbleiterbauelement gemäß dem nicht erfindungsgemäßen Beispiel der Figur 9 eine reflektierende Schicht 14 auf, die die Seitenflanken 6 des Halbleiterchips 1 teilweise bedeckt. Die reflektierende Schicht 14 ist auf dem Bereich der Seitenflanken 6 des Halbleiterchips 1 angeordnet, der an die Kontaktstrukturen 7 angrenzt.

In direktem Kontakt auf die reflektierende Schicht 14 ist die erste Konversionsschicht 11 aufgebracht, die bündig mit der Strahlungsaustrittsfläche 5 des Halbleiterchips 1 abschließt. Auf die erste Konversionsschicht 11 sowie die Strahlungsaustrittsfläche 5 des Halbleiterchips 1 ist wiederum die zweite Konversionsschicht 12 aufgebracht, wie anhand von Figur 5 bereits beschrieben.

Bei den Verfahren gemäß dem erfindungsgemäßen Ausführungsbeispiel der Figuren 10 und 11 werden zunächst die Verfahrensschritte durchgeführt, wie sie anhand der Figuren 1 bis 4 bereits beschrieben wurden. Dann wird das Harz der Konversionsschichten 11, 12 ausgehärtet und der Hilfsträger 2 entfernt (Figur 10). Auf die Hauptfläche des Verbundes aus erster Konversionsschicht 11 und Halbleiterchip 1, die durch das Entfernen des Hilfsträgers 2 freigelegt wird, werden dann metallische Strukturen 15 auf die Kontaktstrukturen 7 aufgebracht (Figur 11). Die metallischen Strukturen 15 erweitern hierbei die Kontaktstrukturen 7 lateral.

Das Halbleiterbauelement gemäß dem nicht erfindungsgemäßen Beispiel der Figur 12 kann beispielsweise mit dem Verfahren, wie es anhand der Figuren 10 und 11 beschrieben ist, hergestellt werden. Im Unterschied zu dem Halbleiterbauelement, wie es bereits anhand von Figur 5 beschrieben wurde, sind bei dem Halbleiterbauelement gemäß der Figur 12 auf jeder Kontaktstruktur 7 eine metallische Struktur 15 angeordnet, die jeweils seitlich über den Halbleiterchip 1 hinausragt und sich bis zu einer Seitenfläche des Halbleiterbauelements erstreckt. Mit Hilfe der metallischen Strukturen 15 kann der Halbleiterchip 1 besser elektrisch kontaktiert werden.

Figur 13 zeigt schematisch einen Verfahrensschritt, wie er beispielsweise nach dem Verfahrensschritt, wie er bereits anhand von Figur 4 beschrieben wurde, durchgeführt werden kann. Bei dem Verfahrensschritt gemäß dem Ausführungsbeispiel der Figur 13 wird auf das ausgehärtete zweite Konversionsmaterial 10 vollflächig eine lichtdurchlässige Schicht 16 aufgebracht. Die lichtdurchlässige Schicht 16 ist beispielsweise aus Silikon oder Glas gebildet. In einem nächsten Schritt werden die Halbleiterbauelemente vereinzelt, wobei beispielsweise mit einem entsprechenden Sägeblatt die Seitenflanken der lichtdurchlässigen Schicht 16 angeschrägt werden (Figur 14). Die lichtdurchlässige Schicht 16 mit den angeschrägten Seitenflächen verbessert die Lichtauskopplung aus dem fertigen Halbleiterbauelement.

Das Halbleiterbauelement gemäß dem nicht erfindungsgemäßen Beispiel der Figur 15 weist im Unterschied zu dem Halbleiterbauelement gemäß der Figur 5 Auskoppelstrukturen 17 auf, die auf die zweite Konversionsschicht 12 aufgesetzt sind. Die Auskoppelstrukturen 17 verbessern ebenfalls die Lichtauskopplung aus dem Halbleiterbauelement.

Figur 16 zeigt eine schematische Darstellung einer Vorrichtung, die der Simulation zur Bestimmung der Konzentration der Leuchtstoffpartikeln in der ersten Konversionsschicht 11 und der zweiten Konversionsschicht 12 zugrunde gelegt werden kann.

Die Vorrichtung gemäß dem Beispiel der Figur 16 weist eine reflektierende Grundplatte 18 mit einer Reflektivität R=0,95 auf. Auf der Grundplatte 18 ist ein Halbleiterchip 1 mit einer Kantenlänge von jeweils 1 mm² aufgebracht. Bei dem Halbleiterchip 1 handelt es sich um einen Flip-Chip.

Über dem Halbleiterchip 1 ist eine hochrefraktive (HRI) Linse 19 angeordnet. In zwei Ecken der Grundplatte ist je eine elektrische Anschlussstelle 20 ausgebildet, die vorliegend Gold aufweisen oder aus Gold gebildet sind.

Ein Flip-Chip, wie er der Simulation zugrunde gelegt wird, ist schematisch in Figur 17 dargestellt. Der Flip-Chip weist einen Träger 4 aus Saphir mit einer Dicke von zirka 115 Mikrometer auf. Weiterhin umfasst die epitaktische Halbleiterschichtenfolge 3 des Halbleiterchips eine n-leitende GaN-Schicht 21 und eine p-leitende GaN-Schicht 22 mit einem Brechungsindex von jeweils etwa 2,5. Der Absorptionskoeffizient der n-leitenden GaN-Schicht 21 wird als 1/cm und der Absorptionskoeffizient der p-leitenden GaN-Schicht 22 wird als 30/cm angenommen.

Innerhalb der epitaktischen Halbleiterschichtenfolge 3 sind zur elektrischen Kontaktierung Knüpfel 23 vorgesehen, die eine innere elektrisch leitende Schicht und eine äußere elektrisch isolierende Schicht aufweisen. Die elektrisch isolierende Schicht kann beispielsweise eines der folgenden Materialien aufweisen oder aus einem der folgenden Materialien gebildet sein: Siliziumoxid, Siliziumnitrid. Die elektrisch leitende Schicht kann beispielsweise eines der folgenden Materialien aufweisen oder aus einem der folgenden Materialien gebildet sein: Titan, Silber.

Auf der epitaktischen Halbleiterschichtenfolge 3 ist eine Spiegelschicht (nicht dargestellt) angeordnet. Die Spiegelschicht weist bei der Simulation eine Reflektivität von ungefähr 0,97 auf. Die Spiegelschicht kann elektrisch leitend oder elektrisch isolierend ausgebildet sein.

Die Kontaktstrukturen 7 sind schließlich beispielsweise aus Silber gebildet und weisen eine Reflektivität von zirka 0,9 auf.

Bei der Simulation wird zunächst eine feste Farbtemperatur für das mischfarbige Licht vorgegeben, das das Halbleiterbauelement aussenden soll, und das aus unkonvertierter elektromagnetischer Strahlung des Halbleiterchips und konvertierter Strahlung der Konversionsschichten zusammengesetzt ist. Beispielsweise beträgt die Farbtemperatur des mischfarbigen Lichtes bei der Simulation 6000 K.

Die Dicke der ersten Konversionsschicht 11 und die Dicke der zweiten Konversionsschicht 12 werden beispielsweise jeweils auf 50 Mikrometer festgelegt, während die Konzentration der Leuchtstoffpartikeln in der zweiten Konversionsschicht 12 variabel ist. Als Leuchtstoff wird in beiden Konversionsschichten 11, 12 beispielsweise ein Granatleuchtstoff wie YAG:Ce verwendet.

Nun wird während einer ersten Simulation die Konzentration der Leuchtstoffpartikeln in der ersten Konversionsschicht 11 konstant gehalten und die Konzentration der Leuchtstoffpartikeln in der zweiten Konversionsschicht 12 iterativ für eine Farbtemperatur von 6000 K bestimmt. Die Simulation wird für verschiedene Konzentrationen der Leuchtstoffpartikel, nämlich c₀=0 Gew%, c₁=10 Gew%, c₂=20 Gew%, c₃=30 Gew%, c₄=40 Gew%, c₅=50 Gew% und c₆=60 Gew% in der zweiten Konversionsschicht 12 wiederholt.

Figur 18 zeigt als Simulationsergebnis die Lichtstärke Iv in Abhängigkeit des Raumwinkels Ω bei verschiedenen Konzentrationen des Leuchtstoffes in der ersten Konversionsschicht 11. Die Konzentrationen der Leuchtstoffpartikeln in der ersten Konversionsschicht 11 beträgt bei der Kurve I₀ 0 Gew%, bei der Kurve I₁ 10 Gew%, bei der Kurve I₂ 20 Gew%, bei der Kurve I₃ 30 Gew%, bei der Kurve I₄ 40 Gew%, bei der Kurve I₅ 50 Gew% und bei der Kurve I₆ 60 Gew%. Die mittlere Halbwertsbreite (FWHM) der Kurven I₀ bis I₆ beträgt ungefähr 155°.

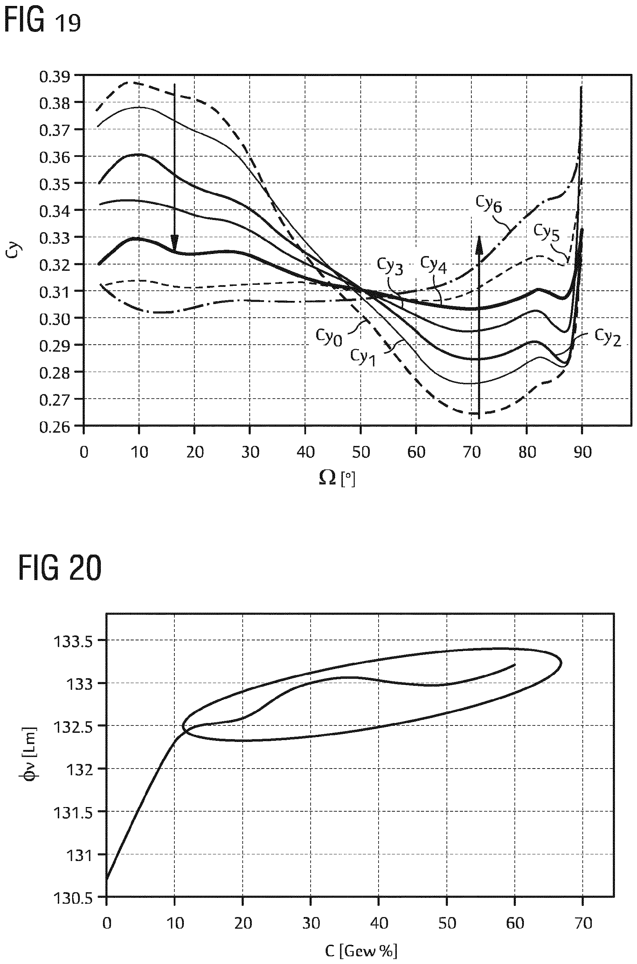

Figur 19 zeigt die Simulationsergebnisse für die Farbkoordinate C_{Y} in Abhängigkeit des Winkels Ω. Die Kurven sind wieder unter Annahme verschiedener Konzentrationen des Leuchtstoffs in der ersten Konversionsschicht 11 ermittelt. Die Konzentrationen der Leuchtstoffpartikeln in der ersten Konversionsschicht 11 beträgt bei der Kurve C_{y0} 0 Gew%, bei der Kurve C_{y1} 10 Gew%, bei der Kurve C_{y2} 20 Gew%, bei der Kurve C_{y3} 30 Gew%, bei der Kurve C_{y4} 40 Gew%, bei der Kurve C_{y5} 50 Gew% und bei der Kurve C_{y6} 60 Gew%. Die Simulation zeigt, dass mit steigender Konzentration der Leuchtstoffpartikeln in der ersten Konversionsschicht 11 ein blauer Ring in einem Außenbereich des Abstrahlkegels des mischfarbigen Lichts ebenso wie ein gelbliches Zentrum des Abstrahlkegels des mischfarbigen Lichts geringer wird (siehe die Pfeile). Bei einer Konzentration der Leuchtstoffpartikeln zwischen 50 % und 60 % weist das Halbleiterbauelement nach der Simulation einen optimierten Farbeindruck über den Raumwinkel auf.

Figur 20 zeigt ein Simulationsergebnis des Lichtstroms Φ_{V} bei einer Farbtemperatur von 6000 K in Abhängigkeit der Konzentration der Leuchtstoffpartikeln c in der ersten Konversionsschicht 11. Figur 20 zeigt, dass die Effizienz des Halbleiterbauelementes besser ist, wenn die Seitenflanken 6 des Halbleiterchips 1 mit Leuchtstoffpartikeln bedeckt sind. Die Effizienz ist um ungefähr 2 % erhöht.

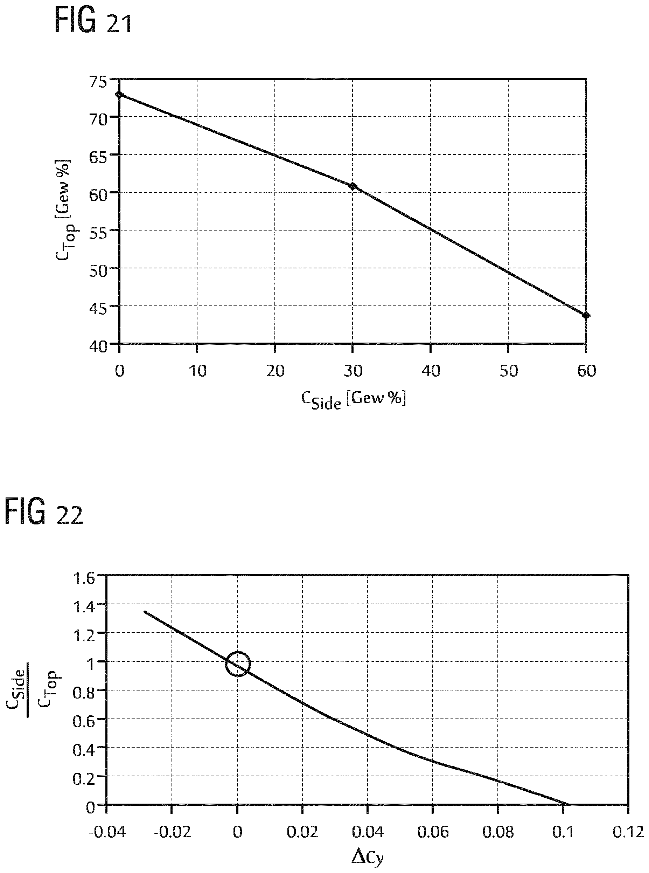

Figur 21 zeigt die Konzentration Cₜₒₚ der Leuchtstoffpartikeln in der zweiten Konversionsschicht 12 auf der Strahlungsaustrittsfläche 5 des Halbleiterchips 1 in Abhängigkeit der Konzentration C_{side} der Leuchtstoffpartikeln in der ersten Konversionsschicht 11 auf der Seitenflanke 6 des Halbleiterchips 1 für eine vorgegebenen Farbtemperatur des von dem Halbleiterbauelement ausgesandten mischfarbigen Lichtes von 6000 K.

Figur 22 zeigt das Verhältnis aus der Konzentration der Leuchtstoffpartikeln in der ersten Konversionsschicht zu der der Konzentration der Leuchtstoffpartikeln in der zweiten Konversionsschicht C_{side}/Cₜₒₚ in Abhängigkeit des Farbkoordinate ΔC_{Y}. Bei der Farbkoordinate ΔC_{Y} handelt es sich um die Differenz zwischen der Farbkoordinate C_{Y} bei 0° und der Farbkoordinate bei 85". Mit anderen Worten ist der Wert ΔC_{Y} ein Maß für die Winkelabhängigkeit des Farborts.

Die Erfindung ist nicht durch die Beschreibung anhand der Ausführungsbeispiele auf diese beschränkt.

## Patentansprüche

1. Verfahren zur Herstellung einer Vielzahl optoelektronischer Halbleiterbauelemente mit den Schritten:
- Aufbringen einer Vielzahl an Halbleiterchips (1) auf einen Hilfsträger (2), die im Betrieb elektromagnetische Strahlung eines ersten Wellenlängenbereichs von einer Strahlungsaustrittsfläche (5) aussenden,
- Aufbringen eines ersten Konversionsmaterials (9) in Zwischenbereiche zwischen den Halbleiterchips (1), wobei das erste Konversionsmaterial (9) dazu geeignet ist, elektromagnetische Strahlung des ersten Wellenlängenbereichs in elektromagnetische Strahlung eines zweiten Wellenlängenbereichs umzuwandeln,
- Aufbringen eines zweiten Konversionsmaterials (10) über das erste Konversionsmaterial (9), wobei das zweite Konversionsmaterial (10) dazu geeignet ist, elektromagnetische Strahlung des ersten Wellenlängenbereichs in elektromagnetische Strahlung eines zweiten Wellenlängenbereichs oder eines dritten Wellenlängenbereichs umzuwandeln,
- Entfernen des Hilfsträgers (2) und
- Vereinzeln der Halbleiterbauelemente, wobei das erste Konversionsmaterial (9) eine erste Konversionsschicht (11) auf den Seitenflanken (6) des Halbleiterchips (1) bildet und das zweite Konversionsmaterial (10) eine zweite Konversionsschicht (12) auf der Strahlungsaustrittsfläche (5) des Halbleiterchips (1) bildet, wobei
- das erste Konversionsmaterial (9) ein erstes flüssiges Harz ist, in das Leuchtstoffpartikeln eingebracht sind, und das zweite Konversionsmaterial (10) ein zweites flüssiges Harz ist, in das Leuchtstoffpartikeln eingebracht sind, und
- die Leuchtstoffpartikel aus dem zweiten Harz in das erste Harz sedimentieren, und
- das erste und zweite Harz vor der Vereinzelung ausgehärtet werden.

2. Verfahren nach dem vorherigen Anspruch,
bei dem vor dem Aufbringen des ersten Konversionsmaterials (9) eine Barriere (8) um die Halbleiterchips (1) in einem Randbereich des Hilfsträgers (2) aufgebracht wird.

3. Verfahren nach einem der obigen Ansprüche,
bei dem vor dem Aufbringen des ersten Konversionsmaterials (9) ein reflektierendes Material (13) in die Zwischenbereiche zwischen den Halbleiterchips (1) aufgebracht wird.

4. Verfahren nach einem der obigen Ansprüche,
bei dem
- der Hilfsträger (2) entfernt wird, so dass eine rückseitige Kontaktstruktur (7) des Halbleiterchips (1) frei zugänglich ist und
- die Kontaktstruktur (7) durch Aufbringen einer metallischen Struktur (15) seitlich erweitert wird.

5. Verfahren nach dem vorherigen Anspruch,
bei dem die metallische Struktur (15) gedruckt wird oder unter Verwendung von Fotolithographie aufgebracht wird.

6. Verfahren nach einem der obigen Ansprüche,
bei dem auf einer von der Strahlungsaustrittsfläche (5) des Halbleiterchips (1) abgewandten Hauptfläche der zweiten Konversionsschicht (12) geometrische Auskoppelstrukturen (17) aufgesetzt werden.

7. Verfahren nach einem der obigen Ansprüche,
bei dem eine lichtdurchlässige Schicht (16) auf die zweite Konversionsschicht (12) aufgebracht wird, die durch den Vereinzelungsschritt an den dabei entstehenden Seitenflanken so strukturiert wird, dass die Auskopplung aus dem Halbleiterbauelement verbessert wird.

8. Verfahren nach einem der obigen Ansprüche,
bei dem die Konzentration der Leuchtstoffpartikeln in dem ersten Konversionsmaterial (9) und die Konzentration der Leuchtstoffpartikeln in dem zweiten Konversionsmaterial (10) durch eine Simulation bestimmt werden.

9. Verfahren nach dem vorherigen Anspruch,
wobei bei der Simulation die folgenden Schritte durchlaufen werden:
- Festlegen einer Farbtemperatur der elektromagnetischen Strahlung des Halbleiterbauelements,
- Festlegen der Konzentration der Leuchtstoffpartikeln in dem ersten Konversionsmaterial (9),
- Bestimmen der Konzentration der Leuchtstoffpartikeln in dem zweiten Konversionsmaterial (10) unter Verwendung der Farbtemperatur und der Konzentration der Leuchtstoffpartikeln in dem ersten Konversionsmaterial (9).

## Claims

1. A method of manufacturing a plurality of optoelectronic semiconductor devices comprising the steps of:
- depositing a plurality of semiconductor chips (1), which in operation emit electromagnetic radiation of a first wavelength range from a radiation exit surface (5), on an auxiliary carrier (2),
- depositing a first conversion material (9) in intermediate regions between the semiconductor chips (1), wherein the first conversion material (9) is suitable for converting electromagnetic radiation of the first wavelength range into electromagnetic radiation of a second wavelength range,
- depositing a second conversion material (10) over the first conversion material (9), wherein the second conversion material (10) is suitable for converting electromagnetic radiation of the first wavelength range into electromagnetic radiation of a second wavelength range or a third wavelength range,
- removing the auxiliary carrier (2) and
- separating the semiconductor components, wherein the first conversion material (9) forms a first conversion layer (11) on the side flanks (6) of the semiconductor chip (1) and the second conversion material (10) forms a second conversion layer (12) on the radiation exit surface (5) of the semiconductor chip (1), wherein
- the first conversion material (9) is a first liquid resin in which phosphor particles are incorporated, and the second conversion material (10) is a second liquid resin in which phosphor particles are incorporated, and
- the phosphor particles sediment from the second resin into the first resin, and
- the first and the second resin are cured before separation.

2. Method according to the previous claim, wherein
a barrier (8) is applied around the semiconductor chips (1) in an edge region of the auxiliary carrier (2) before the application of the first conversion material (9).

3. Method according to any of the above claims,
in which a reflective material (13) is applied to the intermediate regions between the semiconductor chips (1) before the first conversion material (9) is applied.

4. Method according to any of the above claims, wherein
- the auxiliary carrier (2) is removed so that a rear contact structure (7) of the semiconductor chip (1) is freely accessible, and
- the contact structure (7) is expanded laterally by applying a metallic structure (15).

5. Method according to the previous claim,
wherein the metallic structure (15) is printed or applied using photolithography.

6. Method according to any of the above claims,
wherein geometric output coupling structures (17) are placed on a main surface of the second conversion layer (12) facing away from the radiation exit surface (5) of the semiconductor chip (1).

7. Method according to any of the above claims,
wherein a light-transmitting layer (16) is applied to the second conversion layer (12), which is structured by the separation step on the side edges produced in this process in such a way that the decoupling from the semiconductor component is improved.

8. Method according to any of the above claims,
wherein the concentration of the phosphor particles in the first conversion material (9) and the concentration of the phosphor particles in the second conversion material (10) are determined by a simulation.

9. Method according to the previous claim,
wherein the following steps are run through during the simulation:
- determining a color temperature of the electromagnetic radiation of the semiconductor device,
- determining the concentration of the phosphor particles in the first conversion material (9),
- determining the concentration of the phosphor particles in the second conversion material (10) using the color temperature and the concentration of the phosphor particles in the first conversion material (9)

## Revendications

1. Une méthode de fabrication d'une pluralité de dispositifs semi-conducteurs optoélectroniques comprenant les étapes suivantes:
- Application sur un support auxiliaire (2) d'une pluralité de puces à semi-conducteurs (1) qui, en fonctionnement, émettent un rayonnement électromagnétique d'une première gamme de longueurs d'onde à partir d'une surface de sortie du rayonnement (5),
- Application d'un premier matériau de conversion (9) dans des régions intermédiaires entre les puces semi-conductrices (1), le premier matériau de conversion (9) est approprié pour convertir le rayonnement électromagnétique de la première gamme de longueurs d'onde en rayonnement électromagnétique d'une deuxième gamme de longueurs d'onde,
- Application d'un deuxième matériau de conversion (10) sur le premier matériau de conversion (9), dans laquelle le deuxième matériau de conversion (10) est approprié pour convertir le rayonnement électromagnétique de la première gamme de longueurs d'onde en un rayonnement électromagnétique d'une deuxième gamme de longueurs d'onde ou d'une troisième gamme de longueurs d'onde,
- Retiration le support auxiliaire (2) et
- Séparation des composants semi-conducteurs, dans laquelle le premier matériau de conversion (9) forme une première couche de conversion (11) sur les flancs latéraux (6) de la puce semi-conductrice (1) et le deuxième matériau de conversion (10) forme une deuxième couche de conversion (12) sur la surface de sortie du rayonnement (5) de la puce semi-conductrice (1), dans laquelle
- le premier matériau de conversion (9) est une première résine liquide dans laquelle des particules de phosphore sont incorporées, et le second matériau de conversion (10) est une seconde résine liquide dans laquelle des particules de phosphore sont incorporées, et
- les particules de phosphore de la deuxième résine se déposent dans la première résine, et
- la première et la deuxième résine sont durcies avant la séparation.

2. Méthode selon la revendication précédente,
dans laquelle une barrière (8) est appliquée autour des puces semi-conductrices (1) dans une région marginale du support auxiliaire (2) avant l'application du premier matériau de conversion (9).

3. Méthode selon l'une des revendications ci-dessus,
dans laquelle un matériau réfléchissant (13) est appliqué sur les régions intermédiaires entre les puces semi-conductrices (1) avant que le premier matériau de conversion (9) ne soit appliqué.

4. Méthode selon l'une des revendications ci-dessus,
à laquelle
- le support auxiliaire (2) est retiré de manière à ce qu'une structure de contact arrière (7) de la puce semi-conductrice (1) soit librement accessible et
- la structure de contact (7) est élargie latéralement par l'application d'une structure métallique (15).

5. Méthode selon la revendication précédente,
dans laquelle la structure métallique (15) est imprimée ou appliquée par photolithographie.

6. Méthode selon l'une des revendications ci-dessus,
dans laquelle des structures géométriques de couplage de sortie (17) sont placées sur une surface principale de la deuxième couche de conversion (12) qui est opposée à la surface de sortie du rayonnement (5) de la puce semi-conductrice (1).

7. Méthode selon l'une des revendications ci-dessus,
dans laquelle une couche de transmission de la lumière (16) est appliquée sur la deuxième couche de conversion (12), qui est structurée par l'étape de séparation sur les bords latéraux produite dans ce processus de telle sorte que le découplage du composant semi-conducteur est amélioré.

8. Méthode selon l'une des revendications ci-dessus,
dans laquelle la concentration des particules de phosphore dans le premier matériau de conversion (9) et la concentration des particules de phosphore dans le second matériau de conversion (10) sont déterminées par une simulation.

9. Méthode selon la revendication précédente,
où les étapes suivantes sont exécutées pendant la simulation :
- Déterminer une température de couleur du rayonnement électromagnétique du dispositif à semi-conducteur,
- Déterminer la concentration des particules de phosphore dans le premier matériau de conversion (9),
- Déterminer la concentration des particules de phosphore dans le deuxième matériau de conversion (10) en utilisant la température de couleur et la concentration des particules de phosphore dans le premier matériau de conversion (9)
